# FASCICULE DE BREVET EUROPEEN

(11) **EP 2 936 599 B1**
(45) Date de publication et mention de la délivrance du brevet: **22.11.2017**
(21) Numéro de dépôt: 13814094.2
(22) Date de dépôt: 18.12.2013
(51) Int. Cl.: H01M 8/04, G01N 27/14, G01R 31/00

(54) **SYSTÈME DE PILE À COMBUSTIBLE EQUIPÉ D'UN DÉTECTEUR DE FUITE D'HYDROGÈNE**
BRENNSTOFFZELLENSYSTEM MIT DETEKTOR ZUR DETEKTION EINES WASSERSTOFF-LECKS
FUEL CELL SYSTEM WITH DETECTOR FOR DETECTING A HYDROGEN LEAKAGE

(30) Priorité: 19.12.2012 FR 1262342
(43) Date de publication de la demande: 28.10.2015
(73) Titulaire: Compagnie Générale des Etablissements Michelin, 63000 Clermont-Ferrand (FR)
(72) Inventeur: PAGANELLI, Gino, F-63040 Clermont-Ferrand Cedex 9 (FR); JEANRICHARD, Lionel, F-63040 Clermont-Ferrand Cedex 9 (FR)
(74) Mandataire: Roussy, Delphine
(86) Numéro de dépôt international: PCT/EP2013/077012
(87) Numéro de publication internationale: WO 2014/095948

(56) Documents cités:
- EP-A2- 1 521 325
- US-A1- 2008 026 263
- US-A1- 2010 209 787

## Description

### DOMAINE DE L'INVENTION

La présente invention concerne les systèmes à pile à combustible. Plus particulièrement, elle vise les dispositifs permettant d'opérer des mesures en vue du suivi de l'état de ces équipements et de leur conduite opérationnelle.

### ETAT DE LA TECHNIQUE

Les piles à combustible font l'objet à l'heure actuelle de nombreuses études dans le cadre des efforts déployés pour limiter la pollution de l'environnement, dans les transports notamment. Parmi les plus étudiées actuellement figurent sans doute les générateurs électrolytiques à combustible hydrogène, utilisant comme comburant de l'air ou de l'oxygène pur. L'utilisation d'électrolytes solides sous la forme de membranes polymères imprégnées d'eau a permis des progrès considérables. On assiste également en contrepoint au développement d'électrolyseurs, notamment pour effectuer des stockages d'énergie électrique sous forme d'énergie chimique.

Un des sujets majeurs à traiter dans le cadre de développement de ces nouvelles solutions est celui de la sécurité. En effet, les piles à combustible mettent en oeuvre des gaz issus de l'atmosphère, mais également des gaz stockés sous pression. Or, on a constaté que des diffusions intempestives de ces gaz peuvent se produire, soit directement au niveau du moyen de stockage, soit lors d'un transfert de ce gaz du stockage vers la pile à combustible. Certains de ces gaz étant inflammables, il est nécessaire de pouvoir détecter rapidement toute fuite, afin d'éviter des accidents dangereux pour les utilisateurs de ces piles. En outre, afin de ne pas perturber inutilement le fonctionnement des piles à combustible, il est utile de pouvoir éviter toute fausse détection de fuite qui conduirait, par exemple, à un arrêt de la pile non nécessaire.

Ainsi, on a vu se développer ces dernières années des capteurs de concentration de gaz, notamment d'hydrogène, dans des gaz de l'environnement des piles à combustible. De tels capteurs reposent sur une mesure la conductivité thermique à l'aide d'une unité sensible comportant une résistance chauffante dont l'échauffement ou le refroidissement dissipatif est fonction de la conductibilité thermique du gaz ambiant et donc en général de sa composition. Ces capteurs, relativement peu encombrants et simples à mettre en oeuvre, sont particulièrement bien adaptés aux mesures de la teneur d'un gaz en hydrogène en raison de la très forte conductibilité thermique de ce dernier gaz par rapport à celle de la plupart des gaz usuels auxquels il est susceptible d'être mélangé.

Par exemple, la demande publiée EP0291462 décrit ce principe de détection d'un gaz dans l'air sur la base de la variation de conductivité thermique. Plus précisément, ce document montre un micro-capteur de gaz mettant en oeuvre ce principe. L'élément sensible de ce micro-capteur est constitué d'une couche d'oxyde d'étain, obtenue par des techniques classiques d'attaque chimique et de dépôt par pulvérisation à partir d'un substrat de silicium.

On a envisagé d'utiliser un capteur de ce type pour détecter les fuites d'hydrogène dans l'air ambiant, pouvant se produire lors du fonctionnement, ou de l'arrêt, d'une pile à combustible. En effet, avec un tel capteur, il est possible d'utiliser un microcontrôleur permettant de générer un signal analogique représentatif de la concentration en hydrogène mesurée, et ainsi d'alerter en cas d'augmentation forte et imprévue de cette concentration. Toutefois, on a constaté une faille de sécurité dans un tel dispositif, puisque le signal correspondant à une mesure de concentration nulle consécutive à une absence effective d'hydrogène dans l'air est similaire au signal correspondant à une mesure de concentration nulle consécutive à une défaillance du capteur et/ou d'un autre élément du dispositif.

Les demandes publiées EP1521325 et US2008/026263 décrivent un système de piles à combustible comprenant un capteur à hydrogène, ledit capteur délivrant une information de concentration en hydrogène et un signal de bon fonctionnement.

Par conséquent, les dispositifs existants n'offrent pas une fiabilité suffisante ; puisqu'une fuite d'hydrogène peut se produire sans être détectée. La présente invention vise à proposer un dispositif permettant de répondre à cette exigence de fiabilité.

### EXPOSE DE L'INVENTION

Ainsi, la présente invention concerne un système à pile à combustible muni d'un moyen de détection de fuite de gaz, et également de moyens permettant de vérifier, en temps réel, le bon fonctionnement du dispositif de détection.

De manière plus précise, la présente invention étant définie dans la revendication 1 concerne un système à pile à combustible, comportant un empilement de cellules électrochimiques, dont chacune comprend au moins une plaque d'électrode possédant une face en contact électrique avec un électrolyte; au moins une tubulure reliée à ladite face de chacune des cellules dans un circuit d'échange d'un gaz avec l'extérieur de l'empilage;
un détecteur sensible à la concentration d'hydrogène dans l'air environnant l'empilement; le dit capteur comprenant une unité sensible exposée directement à la concentration in situ d'un composant dudit gaz, et
au moins un microcontrôleur,
Ledit système à pile à combustible est caractérisé en ce que le microcontrôleur comprend des moyens pour générer et transmettre, à partir de la mesure de concentration, une information analogique de concentration, et des moyens pour générer et transmettre un signal analogique de bon fonctionnement du détecteur.

De manière avantageuse, le gaz dont la concentration est mesurée est l'hydrogène.

Par ailleurs, dans une réalisation avantageuse, le microcontrôleur comprend des moyens de vérification de l'intégrité d'un ou plusieurs composants de l'organe de suivi et/ou du capteur. Ainsi, la présence de ce signal analogique de bon fonctionnement de l'organe de suivi de condition permet d'alerter un utilisateur d'une défaillance d'un élément du dispositif de détection.

En outre, dans une autre réalisation de l'invention, le microcontrôleur comprend des moyens de vérification de cohérence de la mesure de concentration avec l'information analogique de concentration générée.

Dans une autre réalisation de l'invention, le signal analogique de bon fonctionnement est un signal normalement haut. Ainsi, lorsque le dispositif fonctionne correctement, un signal haut est émis, et lorsqu'une défaillance du dispositif est détectée, un signal bas, ou nul, est émis. Ceci permet, en outre, qu'une panne d'alimentation du dispositif soit également interprétée comme une défaillance, puisque dans ce cas le signal analogique ne serait pas émis, ce qui correspond à un signal nul.

Selon l'invention, le détecteur, ou l'organe de suivi de condition, comprend une unique sortie analogique. Dans ce cas, le signal représentatif de la concentration en gaz mesurée, et le signal de bon fonctionnement doivent être émis sur une unique sortie. Par conséquent, il est utile, dans cette configuration, que le signal analogique de bon fonctionnement soit un signal normalement haut émis à intervalles réguliers. Ceci permet d'émettre deux informations distinctes sur une même sortie, sans que ces deux informations ne soient confondues.

### BREVE DESCRIPTION DES FIGURES

D'autres caractéristiques et avantages de l'invention ressortent de la description faite ci-après en référence aux dessins annexés qui montrent, à titre d'exemples non limitatifs, des formes de réalisation de l'objet de l'invention.

La figure 1 est un schéma très simplifié de la réalisation d'un détecteur de concentration d'hydrogène d'un mélange gazeux avec son électronique de traitement notamment mis en oeuvre dans une pile à combustible, conformément à l'invention.

La figure 2 montre l'évolution d'un signal analogique délivré par un capteur selon l'invention.

### DESCRIPTION D'UN OU PLUSIEURS EXEMPLES DE REALISATION

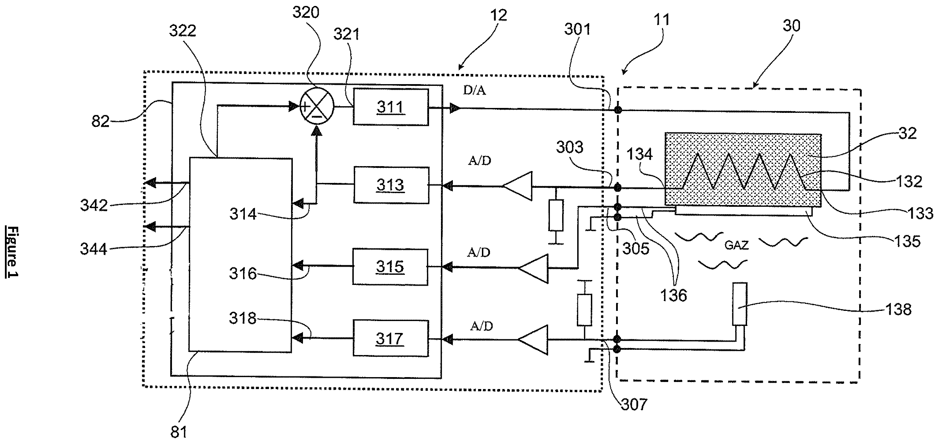

La figure 1 montre un schéma d'un capteur d'hydrogène 11 qui comprend une plaquette 32 de circuits sensibles composée d'un substrat en forme de plaque ou de film, par exemple en silicium. Le substrat est revêtu d'une résistance électrique de chauffage 132, intégrée ou déposée, alimentée à partir de bornes d'alimentation 133 et 134 par une source de courant contrôlée par l'unité de traitement 12. Une des faces de la plaquette 32 comporte un capteur de température 135, par exemple formé par une couche thermoresistive dite PT100, relié par un jeu de conducteurs 136 à l'unité de traitement 12 pour fournir les signaux correspondant à la température instantanée de la plaquette d'unité sensible 32, sous la double action du chauffage et de la dissipation calorifique dans le gaz ambiant. En outre, le capteur de concentration d'hydrogène 11 intègre une sonde de température 138, par exemple une sonde PT 100, pour connaître la température du gaz ambiant. La partie physique de tels capteurs est par exemple décrite dans les documents de brevet EP 0291 462 B1 du 11 mai 1988 et EP 0 501 089 A1 du 25 février 1991.

L'unité de traitement 12 du capteur de concentration d'hydrogène 11 comprend un module numérique 82 relié par quatre lignes de signaux à l'unité sensible 32. Le module numérique 82, schématisé sur la figure 1, est une représentation synoptique des fonctions d'un algorithme implanté dans un microcontrôleur et qui comprend un module de calcul 81 des grandeurs de sortie du capteur de concentration d'hydrogène 11 en direction de l'unité de commande de la pile à combustible.

La première ligne 301 à la sortie de l'unité de traitement 12 contrôle, via un convertisseur numérique/analogique, la tension appliquée sur la résistance de chauffage 132 du capteur de la plaquette 32. La valeur de la tension est commandée à partir d'un étage de régulation de la puissance de chauffage 311 dans l'unité de commande 80. Dans la suite on considère que la résistance de chauffage est alimentée en mode régulation de puissance, cependant d'autres modes d'alimentation de la résistance de chauffage 132 sont possibles, par exemple régulation de tension ou régulation de courant.

La deuxième ligne 303 reçoit le signal de tension image du courant traversant la résistance de chauffage 132. Cette information est convertie par un convertisseur numérique/analogique A/D à l'entrée de l'unité de traitement 12 pour être exploitée par un circuit de contrôle 313 de la puissance de chauffe réellement dissipée dans la résistance 132 du capteur de concentration d'hydrogène 11. On voit sur le schéma que cette information, envoyée à un comparateur 320 dans le module numérique 82 est comparée à une valeur de consigne produite en sortie 322 du module de calcul 81. Dans le module numérique 82, le produit de la comparaison de ces deux grandeurs contrôle l'entrée 321 du régulateur de puissance de chauffe 311. Le chauffage de la plaquette 32 de l'unité sensible 30 est donc généré par une boucle de contre réaction numérique à partir de la consigne de puissance de chauffe affichée à chaque instant à la sortie 322 du module numérique 82. Dans le cas d'une alimentation à tension constante, le régulateur de puissance est remplacé par un régulateur de tension. Même dans le cas d'une régulation de tension, il est important que la puissance réellement dissipée dans la résistance de chauffage soit mesurée par le module numérique 82 pour garantir une bonne précision du calcul de la concentration d'hydrogène.

La troisième ligne 305 permet d'envoyer à une entrée de l'unité de traitement 12 le signal analogique de sortie du capteur de température 135 de la plaquette 32. Après conversion analogique numérique ce signal est exploité par un calculateur de température 315 dans le module numérique 82 qui alimente à son tour le module de calcul 81 avec cette information.

Enfin la quatrième ligne 307 correspond à une entrée de l'unité de traitement 12 qui reçoit la tension de sortie de la sonde de température 138 (température ambiante) et, après conversion analogique numérique, transmet l'information à un calculateur de température 317 dans le module numérique pour l'afficher à l'entrée du module de calcul 81.

Le module de calcul 81 qui reçoit donc, sur ses entrées 314, 316, et 318, les informations de puissance effective de chauffage du capteur, de température de la plaquette 32 et de température ambiante de la sonde de température 138 permet de déterminer : la concentration en hydrogène et la température. L'humidité, quant à elle, peut être déduite d'autres mesures ou être mesurée à partir d'un capteur d'humidité spécifique non représenté.

Le capteur comprend une sortie analogique 342 sur laquelle on retrouve la concentration en hydrogène représentée par un signal entre 0 et 5 volts, et une sortie CAN 344 sur laquelle on retrouve la concentration en hydrogène, avec en plus l'humidité et la température.

Par ailleurs, un capteur selon l'invention comprend, dans le module 82, des moyens pour émettre un signal d'autotest permettant de vérifier, en temps réel, le bon fonctionnement du capteur. Ainsi, ces moyens d'autotest comprennent des moyens permettant de lister toutes les défaillances possibles du capteur. Par ailleurs, le dispositif comprend également une instrumentation spécifique de l'ensemble des éléments de détection, permettant de tester en temps réel les fonctionnalités.

Lorsque les moyens d'autotest déterminent que l'ensemble des fonctionnalités du capteur est active, un signal de bon état de fonctionnement est émis sur la sortie analogique 342, c'est-à-dire sur la même sortie que le signal représentant la concentration en hydrogène. La défaillance d'une seule fonctionnalité entraîne l'émission d'un signal « not ok ». De manière préférentielle, le signal de bon fonctionnement est un signal haut. De manière préférentielle encore, le signal de bon fonctionnement correspond à des artefacts émis régulièrement sur la sortie 342, et qui permettent donc d'indiquer le bon fonctionnement du capteur sans toutefois gêner la transmission de l'information importante, à savoir la concentration en hydrogène.

Le choix d'un signal normalement haut résulte de la volonté de pouvoir également détecter une panne d'énergie dans le détecteur. En effet, une panne d'énergie conduirait à une absence de signal, qui serait ainsi interprétée comme un dysfonctionnement.

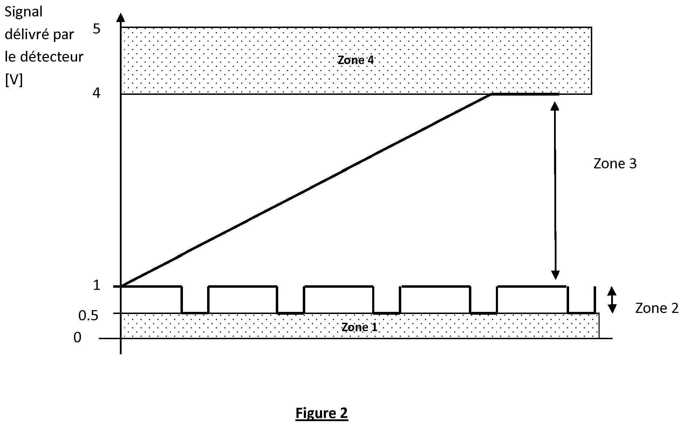

La figure 2 montre ainsi un exemple de signal analogique émis sur la sortie 342 du détecteur. On constate que ce signal est délivré sur une plage de 0 à 5 volts.

Le signal d'autotest est un signal périodique en créneaux, avec une valeur basse égale, par exemple, à 0.5 volts, et une valeur haute égale à 1 volt.

Le signal de détection d'hydrogène est un signal proportionnel. Ainsi, une fuite d'hydrogène est représentée, sur la sortie analogique, par un signal proportionnel, entre 1 et 4 volts. La valeur 1 volt correspond à une concentration de 0% d'hydrogène dans l'air, et la valeur 4 volts correspond à une concentration de 4%.

Ainsi, lorsque le signal délivré par le détecteur est situé entre 0 et 0.5 volts, c'est le signe d'un comportement anormal du détecteur (zone 1 sur la figure 2).

Lorsque le signal délivré est situé entre 0.5 volts et 1 volts, (zone 2 sur la figure 2) cela signifie que le détecteur fonctionne normalement, et qu'aucune fuite d'hydrogène n'est détectée.

Lorsque le signal délivré est situé entre 1 et 4 volts (zone 3 sur la figure 2), cela signifie qu'une fuite d'hydrogène est détectée.

Lorsque le signal délivré est situé entre 4 et 5 volts, c'est le signe d'un comportement anormal du détecteur (zone 4 sur la figure 2).

Ainsi, un arrangement selon la présente invention permet de garantir une détection efficace d'une fuite d'hydrogène et d'un dysfonctionnement du détecteur. En effet, le choix d'un signal autotest périodique permet de prévenir le cas d'un signal qui resterait figé, par exemple à une valeur non nulle. En effet, un tel signal figé pourrait donner l'impression d'un fonctionnement normal du détecteur alors même qu'un dysfonctionnement pourrait avoir survenu.

Par ailleurs, le choix d'une valeur basse du signal périodique non nulle permet de garantir une détection immédiate d'un dysfonctionnement du détecteur. En effet, si le signal d'autotest avait une valeur basse nulle, cela signifierait qu'un signal nul délivré en sortie du capteur ne serait pas nécessairement représentatif d'un dysfonctionnement du capteur. Il faudrait donc attendre le passage à la valeur haute du signal pour avoir la confirmation de l'état de fonctionnement du détecteur. Or, un tel délai d'attente peut s'avérer dangereux dans le cas d'une fuite d'hydrogène massive.

On a donc décrit ici un dispositif de détection de fuite d'hydrogène permettant d'effectuer une détection fiable. En effet, ce dispositif de détection permet de distinguer le cas d'une mesure d'hydrogène nulle parce qu'il n'y a effectivement pas d'hydrogène dans l'air du cas d'une mesure de concentration nulle parce que le détecteur est défaillant. Ceci permet d'assurer une sûreté de fonctionnement nécessaire pour l'utilisation d'un réacteur électrochimique, par exemple sur un véhicule motorisé.

Par ailleurs ce dispositif de détection est relativement facile à installer puisque l'utilisation d'une unique sortie analogique pour émettre le signal de concentration en hydrogène et le signal de bon fonctionnement permet de limiter le nombre de sorties et donc le nombre de câblages à effectuer. Ceci permet également de limiter les coûts supplémentaires d'un tel dispositif.

L'invention n'est bien entendu pas limitée aux exemples décrits et représentés et diverses modifications peuvent y être apportées sans sortir de son cadre défini par les revendications annexées.

## Revendications

1. Système à pile à combustible, comportant:
un empilement (22) de cellules électrochimiques (25), dont chacune comprend au moins une plaque d'électrode (108-1) possédant une face en contact électrique avec un électrolyte; au moins une tubulure (24) reliée à ladite face de chacune des cellules dans un circuit d'échange d'un gaz avec l'extérieur de l'empilage;
un capteur (11) sensible à la concentration de ce gaz dans l'air environnant l'empilement; le dit capteur comprenant une unité sensible exposée directement à la concentration in situ d'un composant dudit gaz, et
au moins un microcontrôleur,
**caractérisé en ce que** le microcontrôleur comprend
- des moyens pour générer et transmettre, à partir de la mesure de concentration, une information analogique de concentration, et
- des moyens pour générer et transmettre un signal analogique de bon fonctionnement du détecteur, et
- une unique sortie analogique par laquelle l'information analogique de concentration et le signal analogique de bon fonctionnement sont transmis.

2. Système selon la revendication 1, dans lequel le gaz est de l'hydrogène.

3. Système selon la revendication 1 ou 2, **caractérisé en ce que** ledit microcontrôleur comprend des moyens de vérification de l'intégrité d'un ou plusieurs composants du microcontrôleur et/ou du capteur.

4. Système selon l'une des revendications 1 à 3, **caractérisé en ce que** ledit microcontrôleur comprend des moyens de vérification de cohérence de la mesure de concentration avec l'information analogique de concentration générée.

5. Système selon l'une des revendications 1 à 4, **caractérisé en ce que** le signal analogique de bon fonctionnement est un signal normalement haut.

6. Système selon la revendication 5, **caractérisé en ce que** le signal analogique de bon fonctionnement est un signal normalement haut émis à intervalles réguliers sur la sortie analogique du microcontrôleur.

7. Système selon l'une des revendications précédentes, **caractérisé en ce que** le signal analogique de bon fonctionnement est un signal périodique de type créneau.

8. Système selon la revendication précédente, **caractérisé en ce que** le signal analogique périodique à une valeur inférieure non nulle.

## Patentansprüche

1. Brennstoffzellensystem, umfassend:
einen Stapel (22) elektrochemischer Zellen (25), von denen jede mindestens eine Elektrodenplatte (108-1) mit einer Fläche in elektrischem Kontakt mit einem Elektrolyten; mindestens einen Rohrstutzen (24), der mit der Fläche jeder der Zellen in einem Austauschkreis eines Gases mit der Außenseite des Stapels verbunden ist, umfasst;
einen Sensor (11), der für die Konzentration dieses Gases in der den Stapel umgebenden Luft empfindlich ist; wobei der Sensor eine empfindliche Einheit umfasst, die direkt der In-situ-Konzentration eines Bestandteils des Gases ausgesetzt ist, und
mindestens einen Mikrocontroller,
**dadurch gekennzeichnet, dass** der Mikrocontroller Folgendes umfasst:
- Mittel zum Erzeugen und Übermitteln einer analogen Konzentrationsinformation ausgehend von der Konzentrationsmessung und
- Mittel zum Erzeugen und Übermitteln eines Analogsignals für eine einwandfreie Funktion des Detektors und
- einen einzigen Analogausgang, durch den die analoge Konzentrationsinformation und das Analogsignal für eine einwandfreie Funktion übermittelt werden.

2. System nach Anspruch 1, bei dem das Gas Wasserstoff ist.

3. System nach Anspruch 1 oder 2, **dadurch gekennzeichnet, dass** der Mikrocontroller Überprüfungsmittel für die Integrität einer oder mehrerer Komponenten des Mikrocontrollers und/oder des Sensors umfasst.

4. System nach einem der Ansprüche 1 bis 3, **dadurch gekennzeichnet, dass** der Mikrocontroller Überprüfungsmittel für die Kohärenz der Konzentrationsmessung mit der erzeugten analogen Konzentrationsinformation umfasst.

5. System nach einem der Ansprüche 1 bis 4, **dadurch gekennzeichnet, dass** das Analogsignal für eine einwandfreie Funktion ein normalerweise hochpegeliges Signal ist.

6. System nach Anspruch 5, **dadurch gekennzeichnet, dass** das Analogsignal für eine einwandfreie Funktion ein normalerweise hochpegeliges Signal ist, das in regelmäßigen Intervallen am Analogausgang des Mikrocontrollers ausgegeben wird.

7. System nach einem der vorhergehenden Ansprüche, **dadurch gekennzeichnet, dass** das Analogsignal für eine einwandfreie Funktion ein periodisches Signal vom Zeitschlitztyp ist.

8. System nach dem vorhergehenden Anspruch, **dadurch gekennzeichnet, dass** das periodische Analogsignal einen unteren Wert hat, der nicht null ist.

## Claims

1. Fuel cell system, having:
a stack (22) of electrochemical cells (25), each of which comprises at least one electrode plate (108-1) having one face in electrical contact with an electrolyte; at least one tube (24) connected to the said face of each of the cells in a circuit for exchanging a gas with the exterior of the stack;
a sensor (11) sensitive to the concentration of this gas in the air surrounding the stack; the said sensor comprising a sensitive unit exposed directly to the in situ concentration of a component of the said gas, and
at least one microcontroller,
**characterized in that** the microcontroller comprises
- means for generating and transmitting analogue concentration information on the basis of the concentration measurement, and
- means for generating and transmitting an analogue signal of correct operation of the detector, and
- a single analogue output. Through which the analogue concentration information and the analogue signal of correct operation are transmitted.

2. System according to Claim 1, wherein the gas is hydrogen.

3. System according to Claim 1 or 2, **characterized in that** the said microcontroller comprises means for verifying the integrity of one or more components of the microcontroller and/or of the sensor.

4. System according to one of Claims 1 to 3, **characterized in that** the said microcontroller comprises means for verifying the consistency of the concentration measurement with the analogue concentration information generated.

5. System according to one of Claims 1 to 4, **characterized in that** the analogue signal of correct operation is a normally high signal.

6. System according to Claims 5 and 6, **characterized in that** the analogue signal of correct operation is a normally high signal emitted at regular intervals on the analogue output of the microcontroller.

7. System according to one of the preceding claims, **characterized in that** the analogue signal of correct operation is a periodic signal of the squarewave type.

8. System according to the preceding claim, **characterized in that** the periodic analogue signal has a nonzero lower value.
